# EUROPEAN PATENT APPLICATION

(11) **EP 1 433 872 A1**
(43) Date of publication of application: **30.06.2004**
(21) Application number: 02768070.1
(22) Date of filing: 25.09.2002
(51) Int. Cl.: C23C 14/12, H01C 7/02

(54) **METHOD FOR FORMING RESIN FILM AND METHOD FOR MANUFACTURING ELECTRONIC PARTS**

(30) Priority: 28.09.2001 JP 2001301248
(71) Applicant: Matsushita Electric Industrial Co., Ltd., Kadoma-shi, Osaka-fu, 571-8501 (JP)
(72) Inventor: TAKAI, Yoriko, Toyonaka-shi, Osaka 560-0002 (JP); HONDA, Kazuyoshi, Takatsuki-shi, Osaka 569-0056 (JP); IKEDA, Takashi, Kaizuka-shi, Osaka 597-0033 (JP)
(74) Representative: VOSSIUS & PARTNER
(86) International application number: PCT/JP2002/009887
(87) International publication number: WO 2003/029509

(57) **Abstract**

A method for manufacturing a resin film according to the present invention includes depositing the resin material by heating a resin material at a heating temperature higher than a melting point of the resin material in a reduced pressure atmosphere. The resin material may have a viscosity-average molecular weight ranging from 500 to 1000000. Furthermore, a method for manufacturing an electronic component according to the present invention uses this method for manufacturing the resin film. In accordance with the present invention, a thin resin film can be manufactured with excellent controllability, so that an electronic component including such a resin film can be obtained.

## Description

### TECHNICAL FIELD

The present invention relates to a method for manufacturing a resin film and a method for manufacturing an electronic component.

### BACKGROUND ART

Resin films are used in various fields. For example, they are used as a constituent member of an electronic component such as a capacitor or a PTC thermistor. In general, such resin films have been formed by the application of a resin dissolved in a solvent. In recent years, as electronic components have become smaller and achieved a higher performance than ever, there has been an increasing demand for the formation of a thin resin film in a highly controllable manner.

However, a thin film has been difficult to form with excellent controllability by the forming method with the solvent application. On the other hand, a conventional method for forming a resin film by vapor deposition has only allowed the deposition of resins with a number-average molecular weight of about 300. If resins with a higher molecular weight are to be deposited, heating at a high temperature is necessary, which modifies the resin property. Consequently, there has been a problem that the resin serving as a deposition source and a resin that has been deposited have different properties.

### DISCLOSURE OF INVENTION

With the foregoing in mind, it is an object of the present invention to provide a new method for manufacturing a resin film, a method for manufacturing an electronic component using the same, and a new electronic component obtained by this method. In the following description, heating temperatures and melting points are expressed in centigrade (°C).

In order to achieve the above-mentioned object, a method for manufacturing a resin film of the present invention is a method for manufacturing a resin film by a vapor deposition of a resin material. The method includes depositing the resin material by heating the resin material at a heating temperature higher than a melting point of the resin material in a reduced pressure atmosphere. The resin material may has a viscosity-average molecular weight ranging from 500 to 1000000, for example. Conventionally, it has been known that, when heated at a temperature higher than its melting point, a resin material undergoes oxidation, which causes a deterioration of the resin property. Therefore, no attempt has been made to form a resin film by depositing a resin material with a viscosity-average molecular weight equal to or greater than 500. Under such circumstances, the inventors of the present invention have found that heating in the reduced pressure atmosphere enables the vapor deposition without any deterioration of the resin material. The method of the present invention for manufacturing a resin film is based on this new finding and uses the vapor deposition, which had not been used conventionally, as a method for manufacturing a resin film formed of an organic molecules whose viscosity-average molecular weight is equal to or greater than 500. This allows a thin resin film to be manufactured with excellent controllability.

In the above-described method for manufacturing a resin film, it is preferable that the heating temperature is higher than a decomposition temperature of the resin material in an ambient atmosphere (atmospheric air) and lower than a decomposition temperature of the resin material in the reduced pressure atmosphere. The "decomposition temperature" in the present specification refers to a temperature at which the property of the resin material deteriorates owing to oxidation or the like.

In the above-described method for manufacturing a resin film, the resin material may be a polyethylene whose viscosity-average molecular weight ranges from 500 to 10000. In this case, it is preferable that the heating temperature (°C) is 2.8 to 3.8 times as high as a melting point (°C) of the polyethylene. With this structure, it is possible to form a polyethylene film having substantially the same property as the polyethylene before the deposition.

Furthermore, an electronic component of the present invention is an electronic component including a resin film. The resin film is formed of a resin material whose viscosity-average molecular weight ranges from 500 to 1000000, and the resin film has a thickness ranging from 0.01 to 1 µm. The manufacture of this electronic component is first made possible by the manufacturing method of the present invention. Further, electrically conductive particles or the like may be contained in the resin film.

The above-described electronic component may further include a first electrode and a second electrode that are arranged so as to sandwich the resin film, and electrically conductive particles arranged inside the resin film. The resin material may be a polyethylene whose viscosity-average molecular weight ranges from 500 to 10000. With this structure, it is possible to obtain a PTC thermistor including a thin polyethylene film.

Moreover, a method for manufacturing an electronic component according to the present invention is a method for manufacturing an electronic component including a resin film formed of a resin material. The method includes forming the resin film by a deposition of the resin material by heating the resin material at a heating temperature higher than a melting point of the resin material in a reduced pressure atmosphere. The resin material has a viscosity-average molecular weight ranging from 500 to 1000000, for example. This manufacturing method uses the above-described method for manufacturing a resin film. With this manufacturing method, a thin resin film can be formed with excellent controllability, so that a thin electronic component can be manufactured reliably. Furthermore, since the resin film has substantially the same property as the resin material serving as a material for the resin film, it is possible to manufacture an electronic component with an excellent property.

In the above-described method for manufacturing an electronic component, it is preferable that the heating temperature is lower than a decomposition temperature of the resin material in the reduced pressure atmosphere.

In the above-described method for manufacturing an electronic component, the resin material may be a polyethylene whose viscosity-average molecular weight ranges from 500 to 10000. In this case, it is preferable that the heating temperature (°C) is 2.8 to 3.8 times as high as a melting point (°C) of the polyethylene.

### BRIEF DESCRIPTION OF DRAWINGS

Fig. 1 shows a cross-section of an exemplary PTC thermistor according to the present invention.
Figs. 2A and 2B are sectional views showing a process flow of an exemplary method for manufacturing the PTC thermistor according to the present invention.
Fig. 3 illustrates an exemplary manufacturing apparatus used in a method for manufacturing a resin film according to the present invention.
Fig. 4 is a graph showing the relationship between a deposition temperature and melting points of a polyethylene film and a remaining portion of polyethylene used to form the film.
Fig. 5 is a graph showing changes in weight when polyethylene is heated.

### EMBODIMENT FOR CARRYING OUT THE INVENTION

The following is a description of preferred embodiments of the present invention, with reference to the accompanying drawings.

### First Embodiment

The first embodiment is directed to a method for manufacturing a resin film according to the present invention. In the manufacturing method of the first embodiment, first, a resin material (in the following, sometimes referred to as a resin material A) is provided in a reduced pressure atmosphere. For example, the resin material A is placed in a reduced pressure chamber, or a chamber in which the resin material A is previously provided is decompressed.

Next, in this reduced pressure atmosphere, by heating the resin material A at a heating temperature higher than a melting point of the resin material A, the resin material A is evaporated and then deposited on a base (a substrate, an electrode or the like), thus forming a resin film. In other words, the method of the present invention deposits the resin material A in the reduced pressure atmosphere. After the resin film is formed by depositing the resin material, the resin film may be cross-linked by an electron beam irradiation or the like.

The viscosity-average molecular weight of the resin material A ranges, for example, from 100 to 1000000 (for example 500 to 1000000) and, preferably, from 500 to 5000. The resin material A can be polyethylene (PE), polypropylene (PP), polystyrene (PS), polymethyl methacrylate (PMMA), polyvinyl alcohol (PVA) or polyvinyl butyral (PVB), for example.

The resin material A can be deposited by (i) arranging the resin material A in a container that can be decompressed, (ii) decompressing the container and (iii) heating the resin material A up to a temperature higher than its melting point. At this time, substances that evaporate at a temperature lower than the melting point are considered as impurities in the resin material A. When such substances are mixed in a resin film, desired characteristics cannot be obtained in some cases. Although the pressure in the container at the time of deposition varies depending on a measuring position, it is not greater than 1.0 × 10⁻¹ Pa, for example, and ranges from 1.0 × 10⁻³ Pa to 1.0 × 10⁻¹ Pa, more specifically. The pressure near an evaporation location for the resin material A is about 1 to 10 Pa, for example.

It is preferable that the heating temperature of the resin material A is higher than a decomposition temperature of the resin material A in an ambient atmosphere (atmospheric air) and lower than a decomposition temperature thereof in the reduced pressure atmosphere (at a pressure inside the container). Herein, the ambient atmosphere (atmospheric air) refers to air at 1 atmospheric pressure (1.01 × 10⁵ Pa). In the manufacturing method of the present invention, since the resin material A is heated in the reduced pressure atmosphere, it can be heated at a temperature higher than the decomposition temperature thereof in an ambient atmospheric. When the resin material A is polyethylene with a viscosity-average molecular weight ranging from 100 to 10000 (for example, 500 to 10000, preferably 500 to 5000), it is preferable that the heating temperature is 2.8 to 3.8 times (more preferably, 2.8 to 3.4 times) as high as the melting point of the polyethylene or ranges from 350°C to 480°C (more preferably, 350°C to 425°C). The heating temperature may be 2 to 4.5 times as high as the melting point of the polyethylene depending on the pressure in the chamber. For other resin material, the heating temperature may be 2 to 4.5 times (preferably, 2.8 to 3.8 times) as high as the melting point of the resin material.

In accordance with this manufacturing method, a resin film as thin as, for example, 0.01 to 1.0 µm (generally, 0.05 to 0.5 µm) can be formed with excellent controllability.

### Second Embodiment

The second embodiment is directed to an example of an electronic component of the present invention and a method for manufacturing the same. The electronic component of the present invention includes a resin film, which is manufactured by the manufacturing method of the first embodiment. The method of the present invention for manufacturing an electronic component includes a process of manufacturing a resin film by the manufacturing method described in the first embodiment.

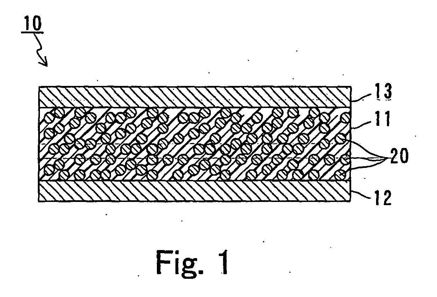

In the following, a PTC thermistor and a method for manufacturing the same will be described as an example of the electronic component of the present invention and the method for manufacturing the same. Fig. 1 shows a cross-section of a PTC thermistor 10 of the second embodiment.

Referring to Fig. 1, the PTC thermistor 10 includes a polyethylene film 11 containing electrically conductive particles 20, and a first electrode 12 and a second electrode 13 that are arranged so as to sandwich the polyethylene film 11.

The polyethylene film 11 is made of polyethylene whose viscosity-average molecular weight ranges from 100 to 10000 (preferably 500 to 10000), and has a thickness ranging from 0.01 to 1 µm. The electrically conductive particles 20 contained in the polyethylene film 11 can be, for example, carbon particles having a particle diameter of about 0.01 to 0.05 µm. In the PTC thermistor 10, the electrically conductive particles distributed in the polyethylene film 11 control an electrical conductivity between the first electrode 12 and the second electrode 13. Therefore, an increase in the temperature causes the polyethylene film 11 to expand so as to increase an average distance between the electrically conductive particles, thus increasing the resistance between the first electrode 12 and the second electrode 13. Accordingly, the PTC thermistor 10 has a positive temperature coefficient (PTC).

The first electrode 12 and the second electrode 13 can be formed of an electrically conductive material, for example, a metal foil or a metal film. More specifically, a metal foil made of Al, Ni, Cu, Ag, Au or an alloy thereof can be used, for example.

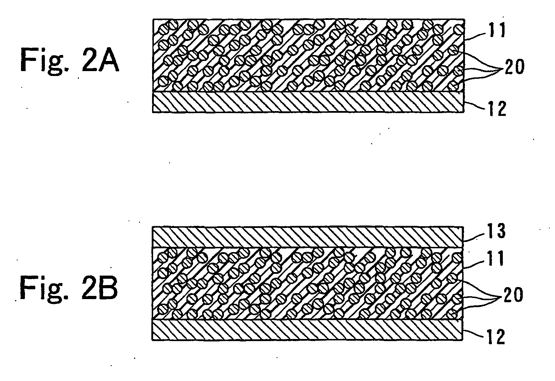

The following is a description of a method for manufacturing the PTC thermistor 10, with reference to Fig. 2. In this manufacturing method, as shown in Fig. 2A, the polyethylene film 11 containing the electrically conductive particles 20 first is formed on the first electrode 12. The polyethylene film 11 is made of polyethylene (in the following, sometimes referred to as a polyethylene A) whose viscosity-average molecular weight ranges from 100 to 10000 (preferably 500 to 10000). The polyethylene film 11 is formed by heating the polyethylene A at the heating temperature higher than the melting point thereof and depositing the polyethylene A on the first electrode 12, in the reduced pressure atmosphere. At this time, the electrically conductive particles also are evaporated at the same time as the polyethylene A, thereby forming the polyethylene film 11 containing the electrically conductive particles. The vapor deposition can be carried out by a manufacturing apparatus 30, which will be described later in the example.

It is preferable that the heating temperature of the polyethylene A at the time of deposition is higher than a decomposition temperature of the polyethylene A in an ambient atmosphere and lower than a decomposition temperature thereof in the reduced pressure atmosphere. More specifically, it is preferable that the heating temperature of the polyethylene A at the time of deposition is 2.8 to 3.8 times (more preferably, 2.8 to 3.4 times) as high as the melting point of the polyethylene A or ranges from 350°C to 480°C (more preferably, 350°C to 425°C). Although the pressure at the time of deposition varies depending on a measuring position, it is not greater than 1.0 × 10⁻¹ Pa, for example, and ranges from 1.0 × 10⁻³ Pa to 1.0 × 10⁻¹ Pa, more specifically. The pressure near an evaporation location of the polyethylene A is about 1 to 10 Pa, for example.

Subsequently, as shown in Fig. 2B, the second electrode 13 is formed on the polyethylene film 11. The second electrode 13 can be formed by vapor deposition, for example. In this manner, the PTC thermistor 10 can be manufactured.

Although the second embodiment has been directed to the PTC thermistor, the present invention also can be applied to an electronic component including a resin film formed of a resin material whose viscosity-average molecular weight ranges from 100 to 1000000 (for example 500 to 1000000, preferably 500 to 5000). More specifically, it can be applied to a resistor, a sensor or a battery, for example. Furthermore, although the second embodiment has been directed to the case where the resin material is polyethylene, the resin material also can be any resin material described in the first embodiment.

### Example

The following is a further specific description of the present invention by way of an example. In this example, an exemplary case of forming a resin film by the manufacturing method of the present invention will be described.

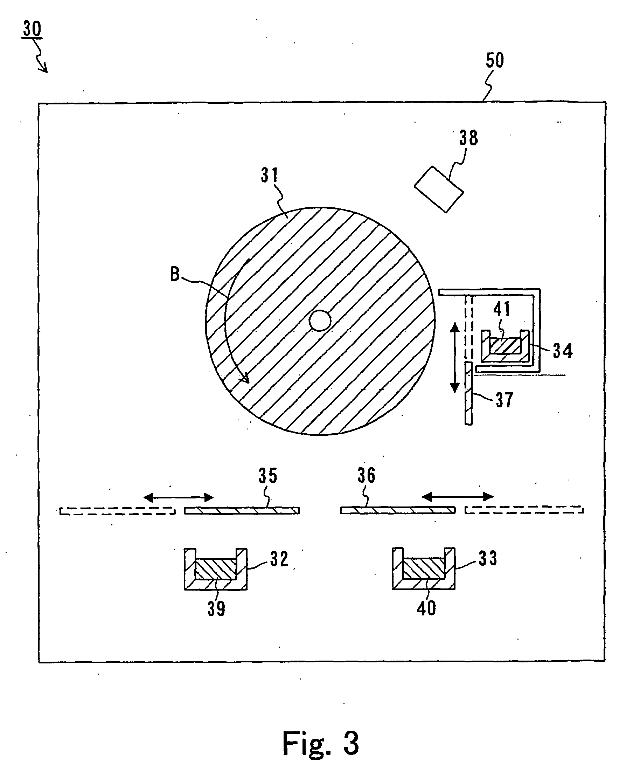

Fig. 3 schematically shows a manufacturing apparatus used in the present example, with the hatching being partially omitted. A manufacturing apparatus 30 shown in Fig. 3 includes a container 50 that can be decompressed, a cooling roller 31 arranged inside the container 50 , crucibles 32 to 34, shutters 35 to 37 and a device 38 for cross-linking a resin material. The device 38 can be, for example, an electron gun emitting an electron beam.

The cooling roller 31 rotates in a direction indicated by an arrow B. An electrode material 39, electrically conductive particles 40 and a resin material 41 respectively are provided in the crucibles 32, 33 and 34, which can be heated independently. The shutters 35 to 37 prevent substances that have been evaporated from the crucibles 32 to 34, from reaching the cooling roller 31 as necessary. In this case, the vapor deposition is performed such that the shutter of the crucible 34 containing the resin material is opened after the crucible is heated up to a desired temperature. This makes it possible to evaporate only a desired component out of the resin material having a broad molecular distribution. The substances that have been evaporated from the crucibles 32 to 34 are deposited on the cooling roller 31. When manufacturing the PTC thermistor 10, first, the electrode material 39 is evaporated from the crucible 32, thus depositing the first electrode on the cooling roller 31. Then, the electrically conductive particles 40 and the resin material 41 are evaporated respectively from the crucibles 33 and 34, thus depositing the resin film containing the electrically conductive particles on the first electrode. Simultaneously, the formed resin film is cross-linked by an irradiation with an electron beam emitted from the device 38. Finally, the electrode material 39 is evaporated from the crucible 32, thus forming the second electrode on the resin film. In this manner, the PTC thermistor 10 is manufactured.

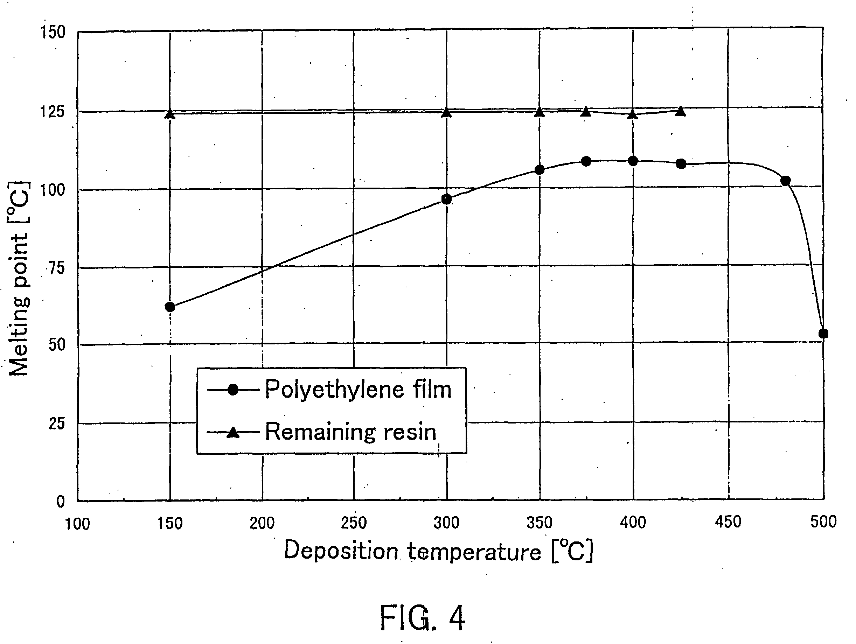

In order to evaluate the characteristics of the resin film formed by the method of the present invention, a resin film made solely of polyethylene whose viscosity-average molecular weight was 2000 (melting point: 125°C) was formed by vapor deposition using the manufacturing apparatus 30. The decomposition temperature of this polyethylene in the ambient atmosphere (atmospheric air) was about 300°C. In this case, the pressure at the evaporation location inside the container was set to be 1 to 10 Pa, and the heating temperature of the crucible 34 containing the polyethylene as a material was changed between 150°C and 500°C. Then, the melting points of the formed polyethylene film and the polyethylene remaining in the crucible 34 were measured. Fig. 4 shows the relationship between the heating temperature of the crucible 34 and the melting points of the formed polyethylene film and the polyethylene remaining in the crucible 34. As shown in Fig. 4, by setting the heating temperature within the range of 350°C to 480°C (the range of 2.8 to 3.8 times as high as the melting point of the polyethylene serving as the material), it was possible to form a polyethylene film whose melting point is substantially equal to that of the polyethylene before the deposition.

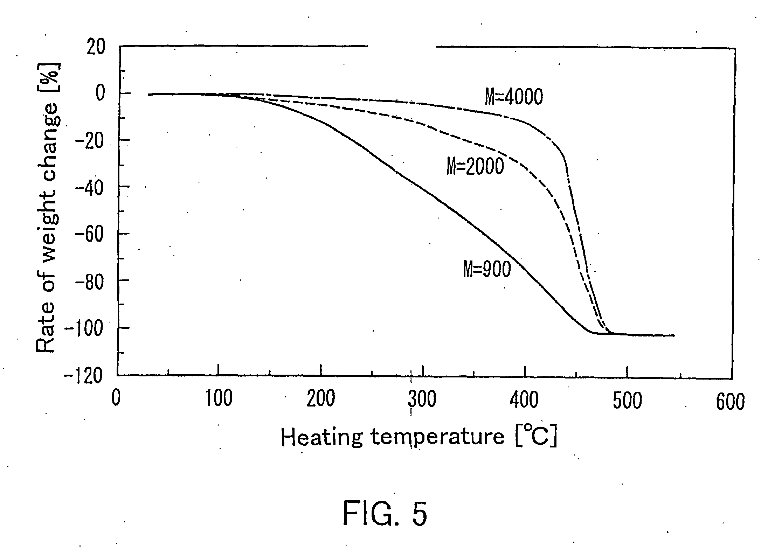

Next, measurements were conducted on changes in weight when polyethylene with a viscosity-average molecular weight of 900, 2000 or 4000 was heated from a room temperature up to about 550°C in a reduced pressure atmosphere. The results of the measurements are shown in Fig. 5. The rate of weight change on the vertical axis indicates how much the weight decreased as a result of the evaporation of polyethylene as the temperature rose. As shown in Fig. 5, their rates of weight change all reach -100% at a certain temperature regardless of their molecular weight. Thus, it was found that the polyethylene evaporated completely at a certain temperature. Furthermore, the weight decreased smoothly with increasing heating temperature. Thus, it was found that polyethylene did not decompose. When vapor deposition is performed at a temperature higher than the melting point under a pressure that is not reduced, the polyethylene generally decomposes, so that the polyethylene serving as the material and the formed polyethylene film have different properties. On the other hand, the method of the present invention makes it possible to form a polyethylene film maintaining the property of the polyethylene serving as the material. In addition, since the method according to the present invention forms a film by vapor deposition, a thin polyethylene film can be formed with excellent controllability.

The invention may be embodied in other specific forms without departing from the spirit or essential characteristics thereof. The embodiments disclosed in this application are to be considered in all respects as illustrative and not restrictive, the scope of the invention being indicated by the appended claims rather than by the foregoing description, all changes that come within the meaning and range of equivalency of the claims are intended to be embraced therein.

### Industrial Applicability

As described above, according to the method of the present invention for manufacturing a resin film, a thin resin film can be formed with excellent controllability. Also, according to the method of the present invention for manufacturing an electronic component, an electronic component including a thin resin film can be manufactured with excellent controllability.

## Claims

1. A method for manufacturing a resin film by a vapor deposition of a resin material, the method comprising:
depositing the resin material by heating the resin material at a heating temperature higher than a melting point of the resin material in a reduced pressure atmosphere.

2. The method according to claim 1, wherein the resin material has a viscosity-average molecular weight ranging from 500 to 1000000.

3. The method according to claim 1, wherein the heating temperature is higher than a decomposition temperature of the resin material in an ambient atmosphere and lower than a decomposition temperature of the resin material in the reduced pressure atmosphere.

4. The method according to claim 1, wherein the resin material is a polyethylene whose viscosity-average molecular weight ranges from 500 to 10000.

5. The method according to claim 4, wherein the heating temperature (°C) is 2.8 to 3.8 times as high as a melting point (°C) of the polyethylene.

6. A method for manufacturing an electronic component comprising a resin film formed of a resin material, the method comprising:
forming the resin film by a deposition of the resin material by heating the resin material at a heating temperature higher than a melting point of the resin material in a reduced pressure atmosphere.

7. The method according to claim 6, wherein the resin material has a viscosity-average molecular weight ranging from 500 to 1000000.

8. The method according to claim 7, wherein the heating temperature is higher than a decomposition temperature of the resin material in an ambient atmosphere and lower than a decomposition temperature of the resin material in the reduced pressure atmosphere.

9. The method according to claim 7, wherein the resin material is a polyethylene whose viscosity-average molecular weight ranges from 500 to 10000.

10. The method according to claim 9, wherein the heating temperature (°C) is 2.8 to 3.8 times as high as a melting point (°C) of the polyethylene.
